# EUROPÄISCHE PATENTSCHRIFT

(11) **EP 1 078 403 B1**
(45) Veröffentlichungstag und Bekanntmachung des Hinweises auf die Patenterteilung: **22.10.2008**
(21) Anmeldenummer: 99932642.4
(22) Anmeldetag: 06.05.1999
(51) Int. Cl.: H01L 29/744, H01L 29/08, H01L 29/417

(54) **ABSCHALTBARER THYRISTOR**
GATE TURN-OFF THYRISTOR
THYRISTOR BLOCABLE

(30) Priorität: 12.05.1998 DE 19821240
(43) Veröffentlichungstag der Anmeldung: 28.02.2001
(73) Patentinhaber: Infineon Technologies AG, 81669 München (DE)
(72) Erfinder: SCHULZE, Hans-Joachim, D-85521 Ottobrunn (DE); SCHUH, Gottfried, D-86169 Augsburg (DE)
(74) Vertreter: Schmuckermaier, Bernhard
(86) Internationale Anmeldenummer: PCT/DE1999/001366
(87) Internationale Veröffentlichungsnummer: WO 1999/059209

(56) Entgegenhaltungen:
- EP-A- 0 064 614
- EP-A- 0 833 390
- "GTO THYRISTOR EMITTER CONFIGURATION" RESEARCH DISCLOSURE, Nr. 289, 1. Mai 1988 (1988-05-01), Seite 342/343 XP000124430 ISSN: 0374-4353
- PATENT ABSTRACTS OF JAPAN vol. 011, no. 117 (E-498), 11. April 1987 (1987-04-11) -& JP 61 263163 A (MITSUBISHI ELECTRIC CORP), 21. November 1986 (1986-11-21)
- PATENT ABSTRACTS OF JAPAN vol. 199, no. 712, 25. Dezember 1997 (1997-12-25) -& JP 09 213933 A (HITACHI LTD), 15. August 1997 (1997-08-15)

## Beschreibung

Die vorliegende Erfindung betrifft einen abschaltbaren Thyristor, bei dem die Filamentierung während des Abschaltvorganges vermieden ist.

Abschaltbare Thyristoren neigen während des Abschaltvorgangs zur Filamentierung, da sie sehr viele parallel geschaltete Einzelthyristoren enthalten. Auslöser für diese Filamentierungen sind laterale Inhomogenitäten im Bauelement, die sich z. B. durch die endliche Leitfähigkeit der kathodenseitigen Metallisierung, inhomogene Verteilungen der Dotierungsprofile und der Trägerlebensdauer, inhomogene Druckkontaktierung oder inhomogene Ätzstrukturierungen ergeben können. Diese Stromfilamentierung führt dazu, daß der maximale Strom, den das Bauelement zerstörungsfrei abschalten kann, stark erniedrigt wird.

Durch den Einsatz von Vorwiderständen kann diese Filamentierung erheblich verringert werden, da der sich längs dieser Vorwiderstände einstellende Spannungsabfall der Filamentierung entgegenwirkt. Es ist hierbei allerdings zu beachten, daß dieser Spannungsabfall nicht zu hoch wird, da ansonsten die Durchlaßspannung der Bauelemente zu stark ansteigt. Im Prinzip lassen sich Vorwiderstände realisieren, indem man Polysilizium auf dem kathodenseitigen Emitter abscheidet. Das erfordert jedoch einen erheblichen technischen Aufwand, und der Bereich, in dem der Widerstand eingestellt werden kann, ist eng begrenzt.

Aufgabe der vorliegenden Erfindung ist es, einen abschaltbaren Thyristor anzugeben, bei dem die sich durch Filamentierung ergebenden Effekte weitgehend vermieden sind.

Diese Aufgabe wird mit dem Thyristor mit den Merkmalen des Anspruches 1 gelöst. Ausgestaltungen ergeben sich aus den abhängigen Ansprüchen.

Bei dem erfindungsgemäßen Thyristor ist kathodenseitig ein Vorwiderstand eingebaut. Der Vorwiderstand wird durch eine durchbrochene Isolierungsschicht zwischen der kathodenseitigen Metallisierung, die den Anschlußkontakt bildet, und dem dotierten Halbleitermaterial des kathodenseitigen Emitters gebildet. Die Öffnungen in dieser Isolierungsschicht sind vorzugsweise zylindrisch. Die Isolierungsschicht ist bei einem Bauelement aus Silizium vorzugsweise SiO₂ oder Si₃N₄ oder eine Schichtfolge aus SiO₂ und Si₃N₄,

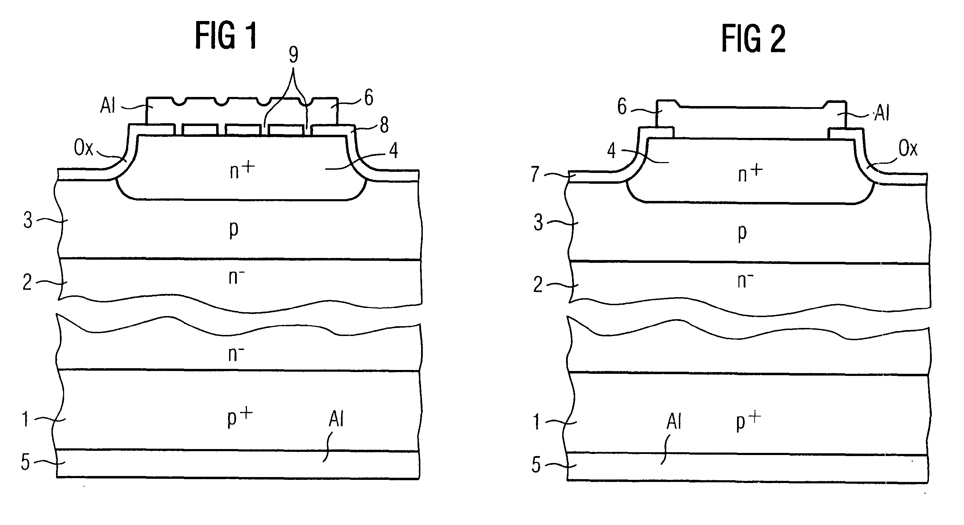

Es folgt eine genauere Beschreibung des erfindungsgemäßen Thyristors anhand der Figuren 1 und 2, die einen erfindungsgemäßen Thyristor bzw. einen herkömmlichen Thyristor im Querschnitt zeigen.

Aus der EP 0 064 614 A2 ist ein Thyristor bekannt, bei dem zwischen dem n-Emitter und der Kathodenelektrode eine mit Lücken versehene Dielektrikumsschicht angeordnet ist. Die Kathodenelektrode erstreckt sich in diese Lücken und kontaktiert dort den n-Emitter.

In Figur 2 ist im Querschnitt ein konventioneller Aufbau eines Thyristors dargestellt. Eine anodenseitige Emitterschicht 1, eine anodenseitige Basisschicht 2, eine kathodenseitige Basisschicht 3 und eine kathodenseitige Emitterschicht 4 folgen aufeinander. Die Emitterschichten sind mit einem Anodenkontakt 5 bzw. mit einem Kathodenkontakt 6 versehen. Ein Kontakt für die kathodenseitige (p-dotierte) Basisschicht 3, der als Gate zur Steuerung des Thyristors dient, ist der Übersichtlichkeit halber in der Figur weggelassen und ist bei dem Thyristor in der üblichen Weise angebracht. Zur besseren Kontaktierung sind die Emitterschichten vorzugsweise ausreichend hoch dotiert, um einen ohmschen Metall-Halbleiterkontakt auszubilden. Es können statt dessen zusätzliche hoch dotierte Kontaktschichten aus Halbleitermaterial vorhanden sein, oder die Emitterschichten weisen jeweils eine zum Kontakt 5, 6 hin ansteigende Dotierungskonzentration auf.

Bei der typischen Ausführungsform eines solchen Thyristors, wie sie in der Figur 2 dargestellt ist, wird der kathodenseitige pn-Übergang an die kathodenseitige Oberseite des Bauelementes geführt und dort vorzugsweise mit einer elektrisch isolierenden Schicht passiviert. Eine derartige Isolierungsschicht 7 ist in der Figur 2 lateral zu dem Kathodenkontakt 6 eingezeichnet. Das Bauelement ist vorzugsweise rotationssymmetrisch, so daß die Kontaktfläche zwischen dem Kathodenkontakt 6 und dem Halbleitermaterial des kathodenseitigen Emitters kreisförmig begrenzt ist.

Figur 1 zeigt einen entsprechenden Querschnitt durch einen erfindungsgemäßen Thyristor. Die anodenseitige Emitterschicht 1, die anodenseitige Basisschicht 2, die kathodenseitige Basisschicht 3 und die kathodenseitige Emitterschicht 4 sind wie üblich vorhanden. Ein Anodenkontakt 5 und ein Kathodenkontakt 6 sind auf den jeweiligen Emitterschichten aufgebracht. Im Unterschied zu dem herkömmlichen Aufbau des Thyristors ist hier aber ein kathodenseitiger Vorwiderstand eingebaut. Dazu ist auf der kathodenseitigen Oberseite des Halbleiterkörpers des Thyristors eine Isolierungsschicht 8 aus einem elektrisch isolierenden Material wie z. B. SiO₂ oder Si₃N₄ aufgebracht. Die Kontaktierung der kathodenseitigen Emitterschicht 4 erfolgt durch Öffnungen 9, vorzugsweise zylindrische Löcher, in der Isolierungsschicht 8. Der Kathodenkontakt 6 ist über der Isolierungsschicht 8 aufgebracht, so daß das Metall (z. B. wie in der Figur eingetragen Aluminium) des Kathodenkontaktes 6 im Bereich der Öffnungen 9 in der Isolierungsschicht 8 mit dem Halbleitermaterial der kathodenseitigen Emitterschicht 4 in Kontakt ist.

Durch die Wahl der Abmessungen der Öffnungen 9 in der Isolierungsschicht 8 (beispielsweise der Zylinderdurchmesser) und durch eine geeignete Festlegung der Abstände dieser Öffnungen untereinander läßt sich die Größe des Vorwiderstandes einstellen. Die Öffnungen werden bevorzugt mit Fotolithografie hergestellt, indem mittels einer Fotomaske Öffnungen der durch die Ausführung der Maske vorgegebenen Abmessungen in der zunächst ganzflächig hergestellten Isolierungsschicht ausgeätzt werden.

Bei dem erfindungsgemäßen Thyristor sind mehrere Kathodenkontakte jeweils auf mehreren parallel angeordneten streifenförmigen Auteilen der Emitterschicht (Emitterfinger) vorhanden. Insbesondere bei kleinen Abmessungen der Öffnungen 9 verbunden mit geringen gegenseitigen Abständen läßt sich nicht nur die Filamentierung über die gesamte Fläche eines solchen Thyristors vermindern, sondern auch die Stromfilamentierung auf jedem einzelnen Emitterfinger. Bei kleinen Abmessungen der Öffnungen ergibt sich außerdem der Effekt, daß sich der Widerstand in dem Kontaktmetall innerhalb der Öffnung durch Zusammenschnüren der elektrischen Feldlinien erhöht.

## Patentansprüche

1. Thyristor mit einem Halbleiterkörper mit einer anodenseitigen Emitterschicht(1), einer anodenseitigen Basisschicht (2), einer kathodenseitigen Basisschicht (3) und einer kathodenseitigen Emitterschicht (4),
- bei dem zwischen der kathodenseitigen Emitterschicht (4) und einem darauf aufgebrachten Kathodenkontakt (6) eine elektrisch isolierende Isolierungsschicht (8) vorhanden ist, die Öffnungen (9) aufweist,
- bei dem die Abmessungen und Abstände dieser Öffnungen (9) so gewählt sind, daß die Isolierungsschicht (8) einen elektrischen Widerstand zur Verminderung von Stromfilamentierung bildet,
- bei dem die kathodenseitige Emitterschicht (4) mehrere Anteile aufweist, und
- bei dem jeder Anteil der kathodenseitigen Emitterschicht (4) mit einem Anteil des Kathodenkontaktes (6) versehen ist,
**dadurch gekennzeichnet, dass**
jeder der Anteile des Kathodenkontaktes (6) durch Öffnungen (9) in der Isolierungsschicht (8) mit dem betreffenden Anteil der kathodenseitigen Emitterschicht (4) in Kontakt ist.

2. Thyristor nach Anspruch 1,
bei dem die Öffnungen (9) in der Isolierungsschicht (8) zylindrisch sind.

3. Thyristor nach einem der Ansprüche 1 oder 2,
bei dem die Grenzfläche zwischen der kathodenseitigen Basisschicht (3) und der kathodenseitigen Emitterschicht (4) zu der kathodenseitigen Oberseite des Halbleiterkörpers hin verläuft und
bei dem die Isolierungsschicht (8) als Passivierung dieser Grenzfläche auf der Oberseite des Halbleiterkörpers aufgebracht ist.

4. Thyristor nach einem der Ansprüche 1 bis 3,
bei dem die Isolierungsschicht (8) mehrere Schichtlagen aus SiO₂ und Si₃N₄ umfaßt.

## Claims

1. Thyristor having a semiconductor body having an anodal emitter layer (1), an anodal base layer (2), a cathodal base layer (3) and a cathodal emitter layer (4),
- in which an electrically insulating insulation layer (8) is present between the cathodal emitter layer (4) and a cathode contact (6) applied thereto, said insulation layer having openings (9),
- in which the dimensions and spacings of said openings (9) are chosen such that the insulation layer (8) forms an electrical resistance for reducing current splitting,
- in which the cathodal emitter layer (4) has a plurality of portions, and
- in which each portion of the cathodal emitter layer (4) is provided with a portion of the cathode contact (6),
**characterized in that**
each of the portions of the cathode contact (6) is in contact through openings (9) in the insulation layer (8) with the relevant portion of the cathodal emitter layer (4).

2. Thyristor according to Claim 1,
in which the openings (9) in the insulation layer (8) are cylindrical.

3. Thyristor according to either of Claims 1 or 2,
in which the interface between the cathodal base layer (3) and the cathodal emitter layer (4) runs towards the cathodal top side of the semiconductor body, and
in which the insulation layer (8) is applied as passivation of said interface on the top side of the semiconductor body.

4. Thyristor according to any of Claims 1 to 3,
in which the insulation layer (8) comprises a plurality of layer elements composed of SiO₂ and Si₃N₄.

## Revendications

1. Thyristor comprenant un corps semi-conducteur ayant une couche (1) d'émetteur du côté de l'anode, une couche (2) de base du côté de l'anode, une couche (3) de base du côté de la cathode et une couche (4) d'émetteur du côté de la cathode,
- dans lequel il y a, entre la couche (4) d'émetteur du côté de la cathode et une couche (6) de contact déposée dessus, une couche (8) isolante du point de vue électrique, qui a des ouvertures (9),
- dans lequel les dimensions de ces ouvertures (9) et leur distance entre elles sont choisies de manière à ce que la couche (8) isolante forme une résistance électrique pour diminuer la filamentation du courant,
- dans lequel la couche (4) d'émetteur du côté de la cathode à plusieurs parties, et
- dans lequel chaque partie de la couche (4) d'émetteur du côté de la cathode est munie d'une partie du contact (6) de cathode,
**caractérisé en ce que** chacune des parties du contact (6) de la cathode est, par des ouvertures (9) dans la couche (8) isolante, en contact avec la partie concernée de la couche (4) d'émetteur du côté de la cathode.

2. Thyristor selon la revendication 1,
dans lequel les ouvertures (9), dans la couche (8) isolante, sont cylindriques.

3. Thyristor selon la revendication 1 ou 2,
dans lequel l'interface entre la couche (3) de base du côté de la cathode et de la couche (4) d'émetteur du côté de la cathode s'étend jusqu'à la face supérieure du côté de la cathode du corps semi-conducteur et
dans lequel la couche (8) isolante est déposée en tant que passivation de cet interface sur le côté supérieur du corps semi-conducteur.

4. Thyristor selon l'une des revendications 1 à 3,
dans lequel la couche (8) isolante comprend plusieurs strates de couche en SiO₂ et en Si₃N₄.
